# FASCICULE DE BREVET EUROPEEN

(11) **EP 1 992 020 B1**
(45) Date de publication et mention de la délivrance du brevet: **03.08.2011**
(21) Numéro de dépôt: 07731096.9
(22) Date de dépôt: 06.03.2007
(51) Int. Cl.: H01L 33/32, H01L 21/203, H01L 21/265

(54) **PROCEDE DE PREPARATION D'UN SEMI-CONDUCTEUR**
VERFAHREN ZUR HERSTELLUNG EINES HALBLEITERS
METHOD FOR PREPARING A SEMICONDUCTOR

(30) Priorité: 08.03.2006 FR 0602063
(43) Date de publication de la demande: 19.11.2008
(73) Titulaire: COMMISSARIAT A L'ENERGIE ATOMIQUE, 75015 Paris (FR); CENTRE NATIONAL DE LA RECHERCHE SCIENTIFIQUE, 75794 Paris Cedex 16 (FR)
(72) Inventeur: DAUDIN, Bruno, F-38700 La Tronche (FR); MARIETTE, Henri, F-38000 Grenoble (FR)
(74) Mandataire: Boubal, Denis Henri Jacques
(86) Numéro de dépôt international: PCT/FR2007/000397
(87) Numéro de publication internationale: WO 2007/104848

(56) Documents cités:
- US-A1- 2002 053 679
- TAKIZAWA T: "Novel method for the activation of acceptor dopant in AlN introducing localized band by isoelectronic dopant" GAN AND RELATED ALLOYS - 2003 SYMPOSIUM (MATER. RES. SOC. SYMPOSIUM PROCEEDINGS VOL.798) MATER. RES. SOC WARRENDALE, PA, USA, 2004, pages 557-562, XP009072827 ISBN: 1-55899-736-9
- ZHANG J-P ET AL: "p-Type co-doping study of GaN by photoluminescence" JOURNAL OF CRYSTAL GROWTH, ELSEVIER, AMSTERDAM, NL, vol. 197, no. 1-2, 1 février 1999 (1999-02-01), pages 368-371, XP004153148 ISSN: 0022-0248
- KOROTKOV R Y ET AL: "OPTICAL STUDY OF GAN: MN CO-DOPED WITH MG GROWN BY METAL ORGANIC VAPOR PHASE EPITAXY" PHYSICA B. CONDENSED MATTER, AMSTERDAM, NL, vol. 308-310, décembre 2001 (2001-12), pages 18-21, XP001205452 ISSN: 0921-4526
- HAN B ET AL: "Optical properties of Mn4+ ions in GaN:Mn codoped with Mg acceptors" APPLIED PHYSICS LETTERS, AIP, AMERICAN INSTITUTE OF PHYSICS, MELVILLE, NY, US, vol. 84, no. 26, 17 juin 2004 (2004-06-17), pages 5320-5322, XP012073101 ISSN: 0003-6951
- VAN DE WALLE CHRIS G ET AL: "First-principles calculations for defects and impurities: Applications to III-nitrides" JOURNAL OF APPLIED PHYSICS, AMERICAN INSTITUTE OF PHYSICS. NEW YORK, US, vol. 95, no. 8, 15 avril 2004 (2004-04-15), pages 3851-3879, XP012067724 ISSN: 0021-8979
- KOROTKOV R Y ET AL: "Codoping of wide gap epitaxial III-nitride semiconductors" OPTO-ELECTRONICS REVIEW ASSOC. POLISH ELECTRICAL ENGINEERS POLAND, vol. 10, no. 4, 2002, pages 243-249, XP009072840 ISSN: 1230-3402
- KIPSHIDZE G ET AL: "Mg and O codoping in p-type GaN and AlxGa1-xN (0" APPLIED PHYSICS LETTERS, AIP, AMERICAN INSTITUTE OF PHYSICS, MELVILLE, NY, US, vol. 80, no. 16, 22 avril 2002 (2002-04-22), pages 2910-2912, XP012030635 ISSN: 0003-6951
- KOROTKOV R Y ET AL: "Electrical properties of p-type GaN:Mg codoped with oxygen" APPLIED PHYSICS LETTERS, AIP, AMERICAN INSTITUTE OF PHYSICS, MELVILLE, NY, US, vol. 78, no. 2, 8 janvier 2001 (2001-01-08), pages 222-224, XP012028003 ISSN: 0003-6951

## Description

La présente invention concerne un procédé de préparation d'un semi-conducteur, qui trouvera notamment son application dans l'industrie électronique ou optoélectronique.

Plus particulièrement, l'invention concerne un procédé de préparation d'un semi-conducteur III-V de formule chimique générale AlₓGa₁₋ₓN, qui trouvera son utilisation dans des diodes.

La production de diodes électroluminescentes (*LED : abréviation de l'expression anglaise Light Emitting Diode*) est actuellement en plein essor et de nombreuses innovations ont été apportées depuis l'apparition des diodes dans les années 60. En effet, une croissance quasi exponentielle, selon la loi de Craford, a été observée dans l'efficacité lumineuse et a permis d'augmenter la valeur qui était inférieure à 0,2 Im/W lors dé l'apparition sur le marché jusqu'à plus de 20 Im/W aujourd'hui, dépassant ainsi l'efficacité des lampes à incandescence non filtrées.

La technologie à la base des diodes LED repose sur les propriétés des semi-conducteurs. Typiquement, une LED est constituée d'un semi-conducteur possédant des régions de conductivité différente: une première région riche en électrons, dite de type n, et une seconde riche en lacunes électroniques, dite de type p. Les LED les plus récentes, bien que fonctionnant sur le même principe, peuvent faire coexister différents semi-conducteurs (LED à hétérojonction), le principe général restant toutefois le même. Le mouvement des porteurs de charges, nommé communément « porteur », électrons ou trous, au sein de la LED permet par recombinaison de produire des photons.

Les propriétés lumineuses d'un matériau semi-conducteur reposent souvent sur les défauts et les impuretés présentes en son sein. L'utilisation de dopants permet d'apporter des qualités particulières au matériau dont ils modifient la composition, ainsi il est notamment possible d'enrichir le matériau en espèces étrangères afin de lui donner un caractère n ou p plus prononcé.

Le dopage n'est toutefois pas aisé et reste lié à différents facteurs. Il est reconnu notamment que, pour la famille des semi-conducteurs nitrures III-V, et contrairement au dopage de type n, le dopage de type p est souvent difficile à effectuer.

La solubilité du dopant, qui correspond à la concentration maximale que peut atteindre une impureté dans un matériau à l'équilibre thermodynamique, est fortement liée à la température et demeure un facteur limitant important. Le site occupé par le dopant au sein du matériau n'est pas sans conséquence et influe notamment sur son énergie ainsi que sur les propriétés électriques du matériau.

L'apparition de défauts, tels que des lacunes, des atomes autointerstitiels ou des antisites dans la structure du matériau complexifie les possibilités de positionnement pour le dopant et concomitamment les variations de propriétés. Enfin, l'énergie d'ionisation du dopant, qui permet de déterminer la fraction de dopant qui pourra jouer un rôle de porteur, est, elle aussi, liée à la température et influe considérablement sur les propriétés.

Les semi-conducteurs de type III-V contenant de l'azote ont été largement étudiés et semblent être les mieux adaptés pour l'émission de lumière à des longueur d'ondes verte, bleue et ultraviolet (UV) qui n'étaient pas accessibles à des émetteurs de lumières solides.

Le dopage de type p des alliages de nitrure de gallium GaN, nitrure d'aluminium AIN et nitrure d'aluminium gallium AlₓGa₁₋ₓN, lorsque x varie entre 0 et 1, est assez difficile dû au fait que les potentiels des dopants utilisés sont fortement accepteurs (Fischer et al-1995): Mg (220-250 meV), Zn (340 meV), Cd (550 meV), C (230 meV). Ceci provoque un taux d'activation très bas et, par conséquent, un niveau de dopage relativement bas (moins de 10¹⁸ cm-³).

Par exemple, le magnésium Mg, qui est utilisé d'une façon universelle pour le dopage type p des alliages de GaN et AlₓGa₁₋ₓN, se trouve à 220 meV au dessus de la bande de valence de GaN, ce qui conduit à un taux d'activation typique de 1 % à température ambiante.

Des calculs théoriques ont montré que le béryllium Be pourrait être un accepteur efficace, avec une énergie d'activation autour de 60 meV (Bernardini et al-1997). Cela étant, certaines expériences ont montré que l'énergie de liaison du Be est plutôt 240 meV (Nakano et al-2003), ce qui fait du Be un élément peu intéressant en tant que dopant potentiel.

La situation est encore plus dramatique dans le cas de AlGaN car il est connu que l'énergie de certains accepteurs, en particulier de Mg, devient de plus en plus profonde dans des alliages avec une teneur de Al croissante, faisant de ces alliages des composés difficiles à doper. Ceci conduit naturellement à une limitation de leur utilisation pour la production des diodes électroluminescentes type UV.

Une approche pour surmonter les difficultés de dopage de type p consiste à codoper le Mg avec l'oxygène O, le zinc Zn ou avec tout autre élément, tel que décrit, par exemple, par Korotkov et al-2001, Kipshidze et al-2002, Kim et al-2000) ou encore par Van de Walle et al-2004.

Même si une diminution dans l'énergie de liaison a été effectivement observée lorsque le Mg a été codopé avec O, en pratique ceci n'a pas permis d'atteindre les niveaux de dopage désirés.

Par ailleurs, on doit attirer l'attention sur le fait que le codopage est difficile à contrôler puisque le rapport entre les différents codopants doit être précis. Par exemple, on mentionne le fait que l'oxygène est un donneur dans GaN et qu'un contrôle insuffisant dans le co-dopage et dans la teneur en oxygène peut très facilement conduire à un dopage indésirable de type n du produit. Le document "Novel method for the activation of acceptor dopant in AIN introducing localized band by isoelectronic dopant" (TAKIZAWA T, GAN AND RELATED ALLOYS - 2003 SYMPOSIUM (MATER. RES. SOC. SYMPOSIUM PROCEEDINGS VOL.798) MATER. RES. SOC WARRENDALE, PA, USA, 2004, pages 557-562, ISBN: 1-55899- 736-9) décrit un procédé de préparation d'un semi-condudeur III-V comprenant au moins une étape de dopage d'un semi-conducteur de formule générale AlₓGa₁₋ₓN, dans laquelle la valeur indice atomique x représente un nombre compris entre 0 et 1, avec un dopant de type p, accepteur d'électrons, ainsi qu'une étape de codopage avec un codopant susceptible de modifier la structure de la bande de valence.

Au vu de ce qui a été décrit ci-dessus, il apparaît qu'un dopage efficace de type p des alliages de GaN, AlN and AlₓGa₁₋ₓN est d'actualité.

Le but de la présente invention est de proposer un procédé de préparation d'un semi-conducteur III-V qui pallie les inconvénients précités, notamment en ce qui concerne leur dopage.

Un autre but de la présente invention est de proposer en particulier un procédé de dopage de type p des semi-conducteurs de la famille

AlₓGa₁₋ₓN.

Un autre but de la présente invention est de proposer des semi-conducteurs aptes à être utilisés dans la production des diodes, notamment des diodes électroluminescentes dans la zone de l'ultraviolet UV.

Un autre but de la présente invention est de proposer des semi-conducteurs aptes à être utilisés dans l'industrie électronique ou optoélectrique.

D'autres buts et avantages de l'invention apparaîtront au cours de la description qui va suivre, qui n'est donnée qu'à titre indicatif et qui n'a pas pour but de la limiter.

L'invention concerne un procédé de préparation d'un semi-conducteur III-V.

Selon l'invention, ledit procédé comprend au moins une étape de dopage d'un semi-conducteur de formule générale AlₓGa₁₋ₓN, dans laquelle la valeur indice atomique x représente un nombre compris entre 0 et 1, avec un dopant de type p, accepteur d'électrons, ainsi qu'une étape de codopage avec un codopant susceptible de modifier la structure de la bande de valence.

L'invention concerne en outre un semi-conducteur obtenu par le procédé décrit dans la présente invention.

L'invention concerne également l'utilisation d'un tel semi-conducteur dans l'industrie électronique ou optoélectronique.

L'invention concerne par ailleurs un dispositif électronique mettant en oeuvre un semi-conducteur selon l'invention ainsi qu'un dispositif électronique contenant une hétérostructure de semi-conducteurs III-N comprenant:
- un substrat,
- une zone dopée n,
- une zone active,
- une zone dopée p, et
- des contacts électriques, l'un sur la zone n l'autre sur la zone p, chacun de ces contacts étant connecté aux bornes d'une source de courant ou de tension,

caractérisé en ce que la zone dopée p est un semi-conducteur obtenu par le procédé précité selon l'invention.

L'invention concerne aussi une diode électroluminescente contenant une hétérostructure telle que décrite dans la présente invention.

L'invention sera mieux comprise à la lecture de la description suivante accompagnée des dessins en annexe parmi lesquels:
- les figures 1a et 1b représentent schématiquement un dispositif optoélectronique.
- la figure 2 représente schématiquement une LED selon l'invention.

La présente invention concerne un procédé de préparation d'un semi-conducteur III-V.

Plus précisément, selon l'invention, ledit procédé comprend au moins une étape de dopage d'un semi-conducteur de formule générale AlₓGa₁₋ₓN, dans laquelle la valeur indice atomique x représente un nombre compris entre 0 e 1, avec un dopant de type p, accepteur d'électrons, ainsi qu'une étape de codopage avec un codopant susceptible de modifier la structure de la bande de valence, caractérisé en ce que la concentration du codopant utilisé dans l'étape de codopage correspond à sa limite de solubilité dans le semi-conducteur.

Typiquement la densité atomique, correspondant à un nombre d'atomes par unité de volume, sera de l'ordre de 10²² atomes.cm⁻³ des espèces concernées. Les semi-conducteurs préférés sont ceux pour lesquels x est supérieur ou égal à 0,2 et de préférence à 0,25. Au delà de cette valeur les méthodes conventionnelles de dopage, tel que le dopage simple avec du Mg, commencent à être moins efficaces.

Selon un autre mode de réalisation, l'étape de codopage est effectuée avec un codopant notamment choisi parmi les impuretés isoélectroniques du semi-conducteur de formule générale AlₓGa₁₋ₓN.

Les semi-conducteurs III-V particulièrement concernés sont les solutions solides constituées après dopage d'au moins 90% d'un mélange de AIN et de GaN dans toute la gamme de composition, de préférence la proportion sera supérieure ou égale à 98%.

Au sens de l'invention, un dopant ou un codopant sont des espèces chimiques différentes de celles constitutives du semi-conducteur non dopé et représentant moins de 10% de la quantité d'atomes présents dans le semi-conducteur dopé, de préférence moins de 2%. Typiquement, la densité atomique de ces espèces au sein d'un semi-conducteur dopé est toujours de l'ordre de 10¹⁷ à 10²⁰ atomes.cm⁻³.

Selon l'invention tout dopant de type p, c'est à dire tout dopant accepteur d'électrons, comme le zinc Zn, le béryllium Be ou encore le carbone C, peut être utilisé. L'utilisation de magnésium Mg ou de manganèse Mn est particulièrement avantageuse.

Le codopant sera choisi de préférence parmi les impuretés isoélectroniques du semi-conducteur à doper. Au sens de l'invention, une impureté isoélectronique correspond à tout élément susceptible de modifier la structure de bande de valence de telle sorte que la modification de l'énergie de la bande de valence conduise à l'abaissement relatif de l'énergie du dopant de type p dans la bande d'énergie interdite. Selon les inventeurs, les éléments appartenant à la colonne V du tableau périodique sont particulièrement adaptés.

Parmi les éléments de la colonne V, on peut citer l'arsenic As, qui est l'impureté isoélectronique préférée. La concentration du codopant dans le semi-conducteur dopé est de préférence inférieure à 10 %, avantageusement inférieure à 6 %.

Afin de déterminer la variation de structure de la bande, des mesures d'absorption optique peuvent être effectuées. La proportion optimale du codopant, tel que l'As, est celle correspondant à la limite de solubilité dans le semi-conducteur, de l'ordre de 5% dans le semi-conducteur dopé, afin d'assurer une incorporation en site substitutionnel.

Selon un premier mode de réalisation, le dopage et le codopage sont réalisés simultanément durant la croissance du semi-conducteur. Les techniques de croissances employées dans le domaine et connues de l'homme du métier sont utilisables selon l'invention.

Il est souhaitable d'intégrer le dopant et le codopant dans le flux d'éléments en sus des éléments employés pour la croissance du semi-conducteur de formule générale AlₓGa₁₋ₓN. De façon plus précise, le procédé d'épitaxie par jets moléculaires (MBE : de l'anglais Molecular Beam Epitaxy) consiste en la synthèse d'un matériau dont les flux des différents composants, chacun produit par une cellule spécifique, sont envoyés indépendamment les uns des autres sur un substrat adapté.

Ces différentes cellules sont installées dans une chambre où règnent des conditions d'ultravide, typiquement quelques 10⁻⁹ torr, en l'absence de croissance, la pression en cours de croissance dépendant du matériau et variant entre 10⁻⁸ et 10⁻⁴ torrs.

Un procédé MBE de croissance de semi-conducteurs comporte ainsi usuellement des sources solides, typiquement des cellules de gallium Ga, d'aluminium Al, d'indium In, de silicium Si (pour le dopage de type n), de magnésium Mg ou de manganèse Mn (pour le dopage de type p), ainsi qu'une cellule pour la production d'azote atomique par dissociation de l'azote gazeux ou par celle de l'ammoniac.

Bien entendu, d'autres sources solides peuvent être prévues pour le dopage ou le codopage et la liste ci-dessus n'est pas exhaustive. Lors de la croissance, le substrat est porté à une température élevée. Cependant il faut noter que cette température est bien inférieure à celle de l'équilibre thermodynamique du matériau : la croissance par MBE a lieu très loin de l'équilibre thermodynamique.

Selon un second mode de réalisation, le dopage est réalisé, généralement par implantation, après la croissance du semi-conducteur de formule générale AlₓGa₁₋ₓN. L'étape de codopage peut dans ce cas être réalisée de manière simultanée à l'étape de dopage ou alors durant la croissance du semi-conducteur et dans ce cas l'étape de dopage sera réalisée après l'étape de codopage.

Cette dernière méthode est particulièrement adaptée car elle présente l'avantage d'un excellent contrôle de la dose et, dans une certaine mesure, permet une certaine sélectivité spatiale du dopage. En revanche, le dopage par implantation est considéré comme une source de défauts.

Ces défauts d'implantation sont avantageusement éliminés en effectuant un recuit à une température inférieure à celle de la décomposition du matériau déposé, c'est à dire inférieure à celle de sa fusion ou à celle de sa sublimation, selon les cas. Le dépôt d'organo-métalliques en phase vapeur (MOCVD : abréviation de l'expression anglaise Metalorganic Chemical Vapour Deposition) est similaire au procédé MBE dans ses résultats mais diffère sensiblement sous l'angle technique : la chambre n'est pas maintenue sous ultravide, les sources des éléments chimiques individuels sont - comme le nom l'indique - des composés organométalliques.

Un procédé MOCVD comporte ainsi autant de lignes de gaz que de composés nécessaires à la croissance, y compris les dopants et codopants. Il comporte également une ou plusieurs lignes de gaz « porteur », soit l'hydrogène H, ou l'azote N, qui ne contribue pas directement à la croissance mais sert au transport des gaz réactifs. La température lors de la croissance est plus élevée que dans le procédé MBE mais reste inférieure à celle de l'équilibre thermodynamique.

La quantité de dopant de typé p introduite dans le semi-conducteur est adaptée à l'application à laquelle celui-ci est destiné. Ainsi, par exemple, pour une diode LED, elle est typiquement de l'ordre de 10¹⁹ à 10²⁰ atomes.cm⁻³. De manière générale la quantité de dopant présente dans le semi-conducteur dopé représente environ 1% des atomes.

La quantité de codopant est limitée par la solubilité du codopant dans le matériau semi-conducteur, par ailleurs il est préférable qu'elle soit supérieure à celle du dopant. Ainsi, dans le cas de l'As, la quantité présente dans le semi-conducteur dopé représente moins de 5% des atomes et avantageusement moins de 2%. Typiquement, elle est de l'ordre de 5.10²⁰ atomes/cm³.

L'épaisseur du semi-conducteur dopé est généralement de l'ordre du micron pour la plupart des applications, en particulier dans le cas des diodes LED où elle n'excède typiquement pas les 5 microns.

Le présent procédé a notamment comme effet de diminuer l'énergie d'ionisation du dopant, qui est l'un des facteurs clef dans la maîtrise des propriétés des semi-conducteurs, et permet ainsi d'augmenter considérablement le nombre de porteurs disponibles au sein du matériau.

Le procédé, tel que décrit dans la présente invention, comporte de préférence une étape de croissance du semi-conducteur de formule générale AlₓGa₁₋ₓN à partir d'un substrat de départ habituellement utilisé dans le domaine et choisi avantageusement parmi l'oxyde d'aluminium Al₂O₃, le silicium Si, le carbure de silicium SiC, l'oxyde de zinc ZnO, l'arséniure de gallium GaAs ou d'autres substrats permettant une croissance cohérente de nitrure de gallium GaN ou d'AlₓGa₁₋ₓN monocristallin.

A noter que ces substrats peuvent présenter des orientations cristallographiques variées permettant la croissance de GaN également suivant des orientations variées. Un empilement de différentes couches minces de semi-conducteurs peut être déposé sur le substrat, principalement par dépôt d'organo métalliques en phase vapeur (MOCVD) ou par épitaxie par jets moléculaires (MBE). Une couche de AlₓGa₁₋ₓN étant nécessairement incluse à l'ensemble, les couches peuvent successivement être empilées quelle que soit la méthode employée, leur épaisseur demeure également sous contrôle de l'utilisateur en fonction de son objectif propre.

Différents échantillons de GaN sont préparés sur un substrat de GaAs, de saphir (Al₂O₃) ou de SiC, par la même technique MBE ou de MOCVD. Un dopage, par implantation après le dépôt de GaN ou alors simultanément, est réalisé sur une partie des échantillons avec du Mn tel que sa concentration soit inférieure à 5%, un recuit permet de faire disparaître d'éventuels défauts dans le cas d'un dopage par implantation.

L'énergie d'absorption optique des échantillons, dopés ou non, élaborés à partir d'un substrat de SiC ou de saphir est similaire à celle du gap. Il apparaît cependant que le niveau de dopage p du GaN dopé Mn déposé sur GaAs est supérieur à 10¹⁸ atomes.cm⁻³ à température ambiante et que l'énergie d'activation de l'accepteur est de l'ordre de 45 à 60 meV (Edmonds et coll., Appl. Phys. Lett, 86, 152114, 2005), ce qui est significativement plus faible que les 1000 meV observés généralement.

L'analyse de l'échantillon montre que l'arsenic diffuse passivement dans la couche de GaN à partir du substrat GaAs.

Il apparaît donc que la présence simultanée de As et de Mn permet seule d'atteindre le fort niveau de dopage observé. La variation de l'efficacité du dopage est liée à la présence d'As qui modifie localement la structure électronique du GaN ou des alliages AlGaN, comme le prouvent les résultats d'absorption optique et la mise en évidence d'états en dessous du gap.

La mise en oeuvre d'un codopage Mn/As, et plus généralement d'un dopant de type p et d'une impureté isoélectronique, dans la préparation des semi-conducteurs de formule générale AlₓGa₁₋ₓN permet de résoudre les difficultés reconnues du dopage p. Un protocole identique peut être mis en oeuvre pour ce qui concerne les autres dopants p des nitrures: le Mg essentiellement mais également le Zn, le Be, le C par exemple.

Le codopage peut être réalisé indépendamment par le procédé MBE ou par MOCVD, connu de l'homme du métier, avant ou pendant le dopage. La quantité de codopant introduite est typiquement supérieure à celle du dopant et la valeur maximale est égale à la solubilité du codopant dans le semi-conducteur de formule générale AlₓGa₁₋ₓN.

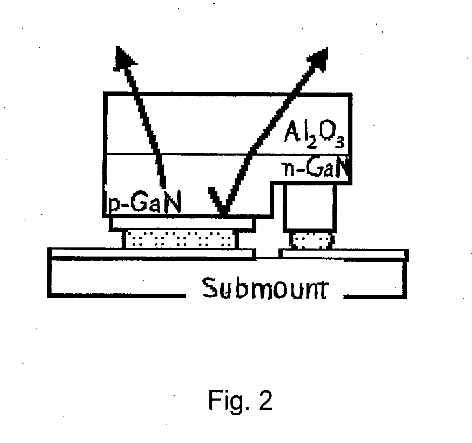

Une diode, telle que représentée sur la figure 2, peut ainsi être fabriquée à partir d'un empilement de différentes couches de semi-conducteurs, dopées ou non. Le substrat de croissance est un semi-conducteur avantageusement transparent comme Al₂O₃, l'épaisseur du substrat est de l'ordre de quelques centaines de microns. La croissance du semi-conducteur dopé est réalisée indépendamment par le procédé MBE ou MCOVD, de telle sorte que le semi-conducteur soit constitué de 94% d'un mélange de AIN et de GaN, de 5 % d'As et de 1 % environ de Mg, de Mn ou de tout autre dopant de type p.

Pour assurer une extraction optimale de la lumière la diode est retournée par rapport au substrat et transférée sur un support (submount) permettant la prise de contact du côté p et du côté n avec des électrodes métalliques. Les photons émis dans la zone active (la ligne pointillée) sont soit émis directement vers le haut à travers le substrat d'Al₂O₃, soit réfléchis à l'interface avec l'électrode métallique servant au contact et renvoyés vers le haut.

L'objet de la présente invention s'étend également aux semi-conducteurs obtenus par l'un quelconque des procédés exposés ci-dessus et à leur utilisation dans tout type d'industrie, plus particulièrement dans le domaine de l'électronique et de l'optoélectronique et, notamment, dans l'industrie automobile, la signalisation routière, l'éclairage domestique et les lasers à base de semi-conducteurs nitrures.

Plus particulièrement, l'objet de la présente invention concerne un semi-conducteur dopé contenant au moins 90 % d'un mélange de AIN et de GaN.

En outre, la présente invention concerne un semi conducteur dopé contenant au moins 98 % d'un mélange de AIN et de GaN.

En outre, la présente invention concerne un semi-conducteur caractérisé par le fait que le dopant de type p est notamment choisi parmi le Zn, Be, C, Mg ou Mn.

Par ailleurs, la présente invention concerne un semi-conducteur dopé caractérisé par le fait qu'il est codopé par une impureté isoélectronique d'un des atomes constituant le semi-conducteur non dopé.

La présente invention concerne également un semi-conducteur dopé qui est codopé par une impureté isoélectronique correspondant à un élément de la colonne V du tableau périodique et, avantageusement, l'As.

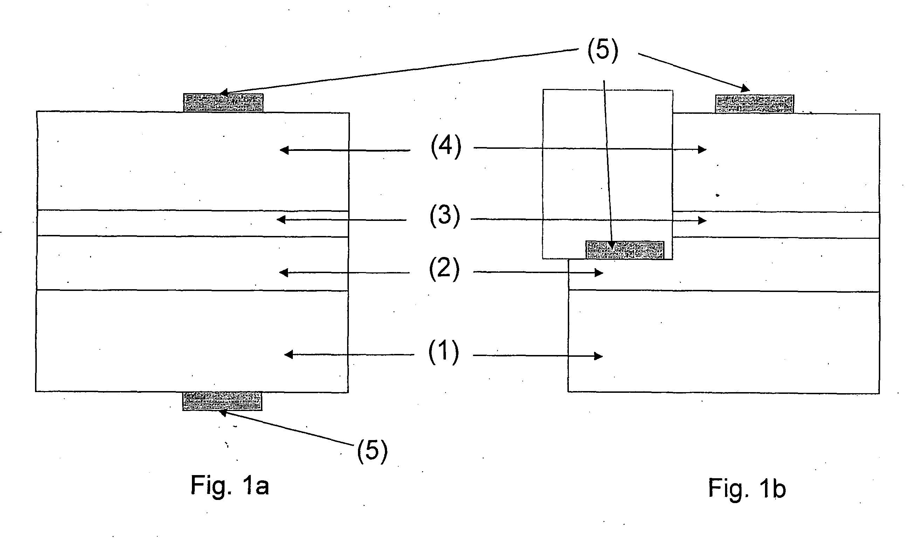

L'invention correspond aussi aux dispositifs électroniques et optoélectroniques mettant en oeuvre les semi-conducteurs dopés présentés ci-dessus. Un dispositif électronique selon l'invention, et tel que montré aux figures 1a et 1b, contient notamment une hétérostructure de semi-conducteurs III-N, ladite hétérostructure comprenant:
- un substrat 1,
- une zone dopée n 2, constituée notamment de n-GaN et de n-AlGaN),
- une zone active 3,
- une zone dopée p 4, constituée d'un semi-conducteur dopé tel que défini ci-dessus, notamment de p-GaN et p-AlGaN, codopée avec une impureté isoélectronique comme de l'As, et
- des contacts électriques 5, l'un sur la zone n l'autre sur la zone p, chacun de ces contacts étant connecté aux bornes d'une source de courant ou de tension qui peut notamment être une simple pile. La zone dopée p est un semi-conducteur obtenu par le procédé décrit ci-dessus.

L'invention concerne également une diode électroluminescente (LED), comme montrée à la figure 2, contenant une hétérostructure telle que décrite précédemment.

Naturellement, d'autres modes de mise en oeuvre, à la portée de l'Homme de l'Art, peuvent être envisagés sans pour autant sortir du cadre de l'invention.

## Revendications

1. Procédé de préparation d'un semi-conducteur III-V comprenant au moins une étape de dopage d'un semi-conducteur de formule générale AlₓGa₁₋ₓN, dans laquelle la valeur indice atomique x représente un nombre compris entre 0 et 1, avec un dopant de type p, accepteur d'électrons, ainsi qu'une étape de codopage avec un codopant susceptible de modifier la structure de la bande de valence, **caractérisé en ce que** la concentration du codopant utilisé dans l'étape de codopage correspond à sa limite de solubilité dans le semi-conducteur.

2. Procédé selon la revendication 1, **caractérisé en ce que** la valeur indice atomique x est supérieur ou égal à 0,2.

3. Procédé selon la revendication 1, **caractérisé en ce que** ledit codopant est choisi parmi les impuretés isoélectroniques du semi-conducteur de formule générale AlₓGa₁₋ₓN.

4. Procédé selon la revendication 1, **caractérisé en ce que** le semi-conducteur contient au moins 90% d'un mélange de AIN et de GaN.

5. Procédé selon la revendication 1, **caractérisé en** en ce que le semi-conducteur contient au moins 98% d'un mélange de AIN et de GaN.

6. Procédé selon la revendication 1, **caractérisé en ce que** le dopant de type p est choisi parmi le Zn, Be, C, Mg ou Mn.

7. Procédé selon la revendication 3, **caractérisé en ce que** l'impureté isoélectronique est un élément de la colonne V du tableau périodique.

8. Procédé selon la revendication 7, **caractérisé en ce que** l'impureté isoélectronique est l'As.

9. Procédé selon la revendication 1, **caractérisé en ce que** la concentration du codopant utilisé dans l'étape de codopage est inférieure à 10%.

10. Procédé selon la revendication 1, **caractérisé en ce que** les étapes de dopage et de codopage sont réalisées simultanément.

11. Procédé selon la revendication 1, **caractérisé en ce que** l'étape de dopage est réalisée après l'étape de codopage.

12. Procédé selon la revendication 1, **caractérisé en ce qu'**il comporte en outre une étape de croissance du semi-conducteur à partir d'un substrat choisi parmi Al₂O₃, Si, SiC, ZnO, GaAs.

13. Semi-conducteur obtenu par le procédé selon l'une quelconque des revendications précédentes.

14. Semi-conducteur selon la revendication 13, **caractérisé en ce qu'**il contient au moins 90 % d'un mélange de AlN et de GaN.

15. Semi-conducteur selon la revendication 13, **caractérisé en ce qu'**il contient au moins 98 % d'un mélange de AIN et de GaN.

16. Semi-conducteur selon la revendication 13, **caractérisé en ce que** le dopant de type p est choisi parmi le Zn, Be, C, Mg ou Mn.

17. Semi-conducteur selon la revendication 13, **caractérisé en ce que** l'impureté isoélectronique est un élément de la colonne V du tableau périodique.

18. Semi-conducteur selon la revendication 13, **caractérisé en ce que** l'impureté isoélectronique est l'As.

19. Utilisation d'un semi-conducteur selon la revendication 13 dans l'industrie électronique ou optoélectronique.

20. Dispositif électronique mettant en oeuvre un semi-conducteur selon la revendication 13.

21. Dispositif électronique contenant une hétérostructure de semi-conducteurs III-N, ladite hétérostructure comprenant:
- un substrat (1),
- une zone dopée n (2),
- une zone active (3),
- une zone dopée p (4), et
- des contacts électriques (5), l'un sur la zone n l'autre sur la zone p, chacun de ces contacts étant connecté aux bornes d'une source de courant ou de tension, **caractérisé en ce que** la zone dopée p est un semi-conducteur obtenu par le procédé selon l'une quelconque des revendications 1 à 12.

22. Diode électroluminescente contenant une hétérostructure selon la revendication 21.

## Claims

1. Method for preparing a III-V semiconductor including at least one step of doping a semiconductor of general formula AlₓGa₁₋ₓN, wherein the atomic number x represents a number between 0 and 1, with a p-type electron-accepting dopant, as well as a codoping step with a codopant capable of modifying the structure of the valency band, **characterised in that** the concentration of the codopant used in the step of codoping corresponds to its limit of solubility in the semiconductor.

2. Method according to claim 1, **characterised in that** the atomic number x is greater than or equal to 0.2.

3. Method according to claim 1, **characterised in that** said codopant is chosen among the isoelectric impurities of the semiconductor of general formula AlₓGa₁₋ₓN.

4. Method according to claim 1, **characterised in that** the semiconductor contains at least 90% of a mixture of AlN and of GaN.

5. Method according to claim 1, **characterised in that** the semiconductor contains at least 98% of a mixture of AlN and of GaN.

6. Method according to claim 1, **characterised in that** the p-type dopant is chosen from among Zn, Be, C, Mg or Mn.

7. Method according to claim 3, **characterised in that** the isoelectric impurity is an element from column V of the periodic table.

8. Method according to claim 7, **characterised in that** the isoelectric impurity is As.

9. Method according to claim 1, **characterised in that** the concentration of the codopant used in the step of codoping is less than 10%.

10. Method according to claim 1, **characterised in that** the steps of doping and of codoping are carried out simultaneously.

11. Method according to claim 1, **characterised in that** the step of doping is carried out after the step of codoping.

12. Method according to claim 1, **characterised in that** it further comprises a step of growing of the semiconductor using a substrate chosen from among Al₂O₃, Si, SiC, ZnO, GaAs.

13. Semiconductor obtained by the method as claimed in any preceding claim.

14. Semiconductor according to claim 13, **characterised in that** it contains at least 90% of a mixture of AlN and of GaN.

15. Semiconductor according to claim 13, **characterised in that** it contains at least 98% of a mixture of AlN and of GaN.

16. Semiconductor according to claim 13, **characterised in that** the p-type dopant is chosen from among Zn, Be, C, Mg or Mn.

17. Semiconductor according to claim 13, **characterised in that** the isoelectric impurity is an element from the column V of the periodic table.

18. Semiconductor according to claim 13, **characterised in that** the isoelectric impurity is As.

19. Use of a semiconductor according to claim 13 in electronics or optoelectronics.

20. Electronic device implementing a semiconductor according to claim 13.

21. Electronic device containing a heterostructure of III-N semiconductors, said heterostructure comprising:
- a substrate (1),
- an n-doped zone (2),
- an active zone (3),
- a p-doped zone (4), and
- electrical contacts (5), one on the zone n and the other on the zone p, each of these contacts being connected to the terminals of a source of current or voltage, **characterised in that** the p-doped zone is a semiconductor obtained by the method according to any of claims 1 to 12.

22. Electroluminescent diode containing a heterostructure according to claim 21.

## Patentansprüche

1. Verfahren zur Herstellung eines Halbleiters III-V zumindest umfassend einen Schritt des Dotierens eines Halbleiters der allgemeinen Formel AlₓGa₁₋ₓN, in der der atomare Indexwert x eine Zahl zwischen 0 und 1 darstellt, mit einem Elektronen akzeptierenden Dotant des Typs p, sowie einen Schritt des Codotierens mit einem Codotant, der die Struktur des Valenzbands ändern kann, **dadurch gekennzeichnet, dass** die Konzentration des Codotanten, der im Schritt des Codotierens eingesetzt wird, seiner Löschlichkeitsgrenze im Halbleiter entspricht.

2. Verfahren nach Anspruch 1, **dadurch gekennzeichnet, dass** der atomare Indexwert x größer oder gleich 0,2 ist.

3. Verfahren nach Anspruch 1, **dadurch gekennzeichnet, dass** der Codotant unter den isoelektrischen Unreinheiten des Halbleiters der allgemeinen Formel AlₓGa₁₋ₓN ausgewählt wird.

4. Verfahren nach Anspruch 1, **dadurch gekennzeichnet, dass** der Halbleiter zumindest 90% einer Mischung aus AIN und GaN enthält.

5. Verfahren nach Anspruch 1, **dadurch gekennzeichnet, dass** der Halbleiter zumindest 98% einer Mischung aus AIN und GaN enthält.

6. Verfahren nach Anspruch 1, **dadurch gekennzeichnet, dass** der Dotant des Typs p unter Zn, Be, C, Mg oder Mn ausgewählt wird.

7. Verfahren nach Anspruch 3, **dadurch gekennzeichnet, dass** die isoelektrische Unreinheit ein Element der Spalte V des Periodensystems ist.

8. Verfahren nach Anspruch 7, **dadurch gekennzeichnet, dass** die isoelektrische Unreinheit As ist.

9. Verfahren nach Anspruch 1, **dadurch gekennzeichnet, dass** die Konzentration des Codotanten, der im Schritt des Codotierens eingesetzt wird, kleiner als 10 % ist.

10. Verfahren nach Anspruch 1, **dadurch gekennzeichnet, dass** die Schritte des Dotierens und des Codotierens gleichzeitig realisiert werden.

11. Verfahren nach Anspruch 1, **dadurch gekennzeichnet, dass** der Schritt des Dotierens nach dem Schritt des Codotierens realisiert wird.

12. Verfahren nach Anspruch 1, **dadurch gekennzeichnet, dass** es des Weiteren einen Schritt des Wachstums des Halbleiters anhand eines Substrats, das unter Al₂O₃, Si, SiC, ZnO, GaAs ausgewählt wird, umfasst.

13. Halbleiter, der mit dem Verfahren nach einem der vorhergehenden Ansprüche erhalten wird.

14. Halbleiter nach Anspruch 13, **dadurch gekennzeichnet, dass** er zumindest 90 % einer Mischung aus AIN und GaN enthält.

15. Halbleiter nach Anspruch 13, **dadurch gekennzeichnet, dass** er zumindest 98 % einer Mischung aus AIN und GaN enthält.

16. Halbleiter nach Anspruch 13, **dadurch gekennzeichnet, dass** der Dotant des Typs p unter Zn, Be, C, Mg oder Mn ausgewählt wird.

17. Halbleiter nach Anspruch 13, **dadurch gekennzeichnet, dass** die isoelektrische Unreinheit ein Element der Spalte V des Periodensystems ist.

18. Halbleiter nach Anspruch 13, **dadurch gekennzeichnet, dass** die isoelektrische Unreinheit As ist.

19. Verwendung eines Halbleiters nach Anspruch 13 in der elektronischen oder optoelektronischen Industrie.

20. Elektronische Vorrichtung, die einen Halbleiter nach Anspruch 13 einsetzt.

21. Elektronische Vorrichtung, die eine Heterostruktur eines Halbleiters III-N enthält, wobei die Heterostruktur folgendes umfasst:
- ein Substrat (1),
- eine dotierte Zone n (2),
- eine aktive Zone (3),
- eine dotierte Zone p (4), und
- elektrische Kontakte (5), einer auf der Zone n, der andere auf der Zone p, wobei jeder dieser Kontakte an die Klemmen einer Strom- oder Spannungsquelle angeschlossen ist, **dadurch gekennzeichnet, dass** die dotierte Zone p ein Halbleiter ist, der mit dem Verfahren nach einem der Ansprüche 1 bis 12 erhalten wird.

22. Elektrolumineszenzdiode, die eine Heterostruktur nach Anspruch 21 enthält.
